# EUROPEAN PATENT SPECIFICATION

(11) **EP 3 535 524 B1**
(45) Date of publication and mention of the grant of the patent: **26.08.2020**
(21) Application number: 17808191.5
(22) Date of filing: 27.10.2017
(51) Int. Cl.: F23D 14/02, H01L 35/32

(54) **BURNER WITH A THERMOELECTRIC GENERATOR**
BRENNER MIT EINEM THERMOELEKTRISCHEN GENERATOR
BRÛLEUR DOTÉ D'UN GÉNÉRATEUR THERMOÉLECTRIQUE

(30) Priority: 03.11.2016 PL 41934916
(43) Date of publication of application: 11.09.2019
(73) Proprietor: AIC Spólka Akcyjna, 81-577 Gdynia (PL)
(72) Inventor: SIEMIENCZUK, Tomasz, 80-351 Gdansk (PL); PACHOLSKI, Adam, 81-603 Gdynia (PL)
(74) Representative: Pomianek, Grazyna
(86) International application number: PCT/PL2017/000112
(87) International publication number: WO 2018/084729

(56) References cited:
- WO-A2-2008/061510
- JP-A- S63 282 408
- JP-A- 2009 194 309
- US-A1- 2012 204 923
- US-B1- 6 198 038

## Description

The invention concerns a burner with a thermoelectric generator, the functioning of which is based on the Seebeck effect, designated in particular for fired heat exchangers in central heating and/or domestic water installations.

The market today expects new technical solutions and devices able to serve a growing number of functions, while at the same time getting more and more universal. Moreover, the entire industry is taking intense effort to develop new methods of generating electric energy. The majority of the micro-generating devices currently available in the market are based on principle of conversion of some form of kinetic energy to electric energy. Known are solutions employing different kinds of reciprocating engines, Stirling engines, turbines, etc. The solutions are characterised by substantial limitations resulting from the high level of their complexity which entails high production cost, as well as by low reliability and high costs related to ensure the required maintenance.

Known are thermoelectric devices employing the Seebeck effect, which enable generation of electric energy. The devices contain thermoelectric technical means where the temperature difference between specific areas enables generation of electric energy.

The current state of the art in the area of thermoelectric coatings implies that no solution has been found yet which would provide instruction on how to apply thermoelectric composites in a comprehensive manner and use them in devices. There are, however, some scientific publications which discuss specific methods of manufacturing the semiconductor components only, intended for thermocouples. It should also be mentioned here that attempts are made to lay layers of bismuth telluride under the thermal spray method. Because of its high imprecision, however, the method proves poorly effective, and the produced systems of poor performance. Because of the open structure of the semiconductor junctions of the 'p' and 'n' type, the systems cannot be used safely.

Currently, the market is saturated only as concerns prefabricated thermocouples. Their fairly substantial limitations stem from their absolute lack of formability and their standardized sizes.

Recently, however, a new application group has been developed for the electricity generating thermocouples: they are used to generate electricity in the so-called hiking power generators. The devices employ heat energy to enable charging small receivers. Because of the size of the target market, however, and the technical solutions used one can hardly speak about industrial scale here. The heretofore experimental attempts at using prefabricated thermocouple modules do not stand any true chance of commercialization because of their production and size-related limitations. Another factor which effectively hampers the development of this specific industry branch is the high unit cost of thermocouples.

Known from a British patent document GB 2 451 521 A is a portable water heater having a combustion chamber, where the heater burns fuel to ensure the source of heating. The combustion chamber is fitted with a fuelled burner and blower supplying air to the burner. The blower is fed with power from a thermoelectric generator which contains a Peltier-Seebeck device having one side hot from the heat produced by the burner and one side cold, cooled by the air supplied by the blower. The fuel is delivered to the burner gravitationally from a petrol can. The thermoelectric generator contains a set of semiconductor modules made of bismuth telluride (BI-TE) connected in series, where the modules produce electric voltage whenever a temperature difference occurs throughout the stack. The water heater does not need to be energy fed and can be used in field kitchens, on a boat, etc.

JPS63282408 A discloses a burner combustion plate applied to a gas water heater, hot air heater or other combustor a plurality of thermoelectricity generating elements which are arranged with their heating sections at one side and their low temperature sections at the other end with their ends being mutually flush with each other to form a planar aggregate of thermoelectricity generating elements. Many through-holes for flame are formed by perforating the heating section. In this constitution, the low temperature part of the aggregate of thermoelectricity generating elements is fully cooled by the mixture gas of the air for combustion and gas so that a desired capacity of thermoelectromotive force can be obtained.

The purpose of the invention is to increase the volume of energy generated in normal operation of the burner, and in particular to provide a burner intended especially for fired heat exchangers in central heating and/or domestic water installations, which would at the same time generate electric energy used for supplying power to additional electronic accessories or external devices, or fed back to the power grid.

The purpose has been achieved by developing a burner fitted with thermoelectric technical means which employ the heat produced in the fuel burning process to generate electric energy.

A burner with a thermoelectric generator, the functioning of which is based on the Seebeck effect, having an external jacket in which nozzles are made which supply the fuel-and-air mix from a fuel-and-air mix duct to the outer surface of the external jacket, where the mix burns, the thermoelectric generator takes the form of a thermoelectric coating applied to these elements of the burner which are in thermal contact with combustion gases, where the coating contains a thermoelectric layer having two semiconductor sub-layers 'p' and 'n' which do not contact each other and are interconnected in series with layered conducting elements fitted with connection ends to evacuate the generated electric energy, and where the coating is electrically insulated on conducting elements with layers of electrical insulator containing inorganic oxides, according to the inventions is characterised in that the fuel-and-air mix duct is formed inside the external jacket, and the width of each semiconductor sub-layer 'p' and 'n' of the thermoelectric layer of the coating ranges from 0.1mm to 2mm, the thickness of the layered conducting elements falls within the range from 1µm to 5µm, whereas the total thickness of the coating is 50 µm or less.
Preferably, the cold side of the semiconductor sub-layers 'p' and 'n' of the thermoelectric layer of the coating is cooled with air and fuel supplied to the burner.
Preferably, the layered conducting elements of the coating are made of copper.
Preferably, the electrical insulator layers of the thermoelectric layer of the coating arc produced based on Al₂O₃ or MgO.
Preferably, inside the external jacket, at some distance therefrom, there is an internal jacket inside which the fuel-and-air duct runs, where applied to the outer side of the internal jacket is the coating which contains the thermoelectric layer, and where there are pass-through holes in the internal jacket and the coating applied thereto, the holes positioned coaxially to one another.
In another variant of the invention, the coating which contains the thermoelectric layer is preferably applied to the inner surface of the external jacket and features pass-through holes positioned coaxially to the nozzles delivering the fuel-and-air mix to the outer surface of the external jacket.
In addition, on the outer surface of the external jacket there is a layer of steel non-woven fabric.
Moreover, the burner has an internal jacket featuring pass-through holes, where there is a fuel-and-air duct running inside the internal jacket. Preferably, the semiconductor sub-layers 'p' and 'n' of the thermoelectric layer of the coating are formed into alternating semiconductor rings 'p' and 'n'.

The invention makes it possible to generate electric energy obtained during regular operation of the burner using the thermoelectric coating embedded in the burner. Besides heat energy, the burner, with its embedded thermoelectric coating, generates electric energy in accordance with the Seebeck effect. The advantage of the solution according to the invention lies in the absence of any movable elements, thanks to which the burner maintenance costs will not grow. Moreover, thanks to the absence of any movable elements, the electric energy generation process is totally sound-free and vibration-free, which will allow installation of the device in higher number of locations, while at the same time minimizing arduousness of the device to the people living and working close to it; it will also ensure scalability of use, ranging from micro-applications to high powers, as well as scalability of production in automated production technology easy to be copied at a large scale. In addition, thanks to taking advantage of the thermoelectric effect, it is possible to generate electricity directly from heat energy, bypassing the conversion to kinetic energy, which will translate to high reliability and lower maintenance costs.

The electric energy produced can find different applications, e.g. in:
- supplying power to electrical sub-assemblies of a complete device, such as control elements or pumping systems (improving energy efficiency)
- building autonomous units independent of external power supply
- delivering energy back to the local power network (reducing the household demand for electric energy)
- delivering energy back to the power grid (micro sources, prosumer, citizen energy)

These and other characteristics of the invention will be clear from the following description of a preferential form of embodiment, given as a non-restrictive example, with reference to the attached drawings wherein:
Fig. 1 shows the burner in axial section in the first exemplary embodiment;
Fig. 2 depicts the burner in axial section in the second exemplary embodiment;
Fig. 3 illustrates the burner in axial section in the third exemplary embodiment;
Fig. 4 shows the burner in axial section in the fourth exemplary embodiment;

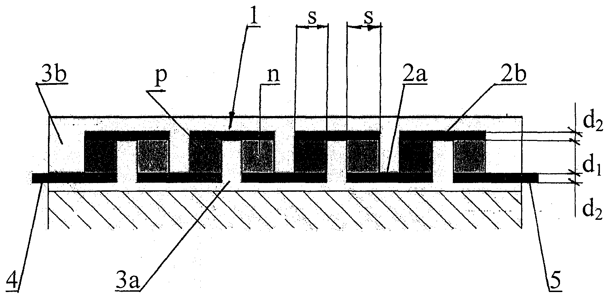

Fig. 5 depicts the thermoelectric coating in cross section.

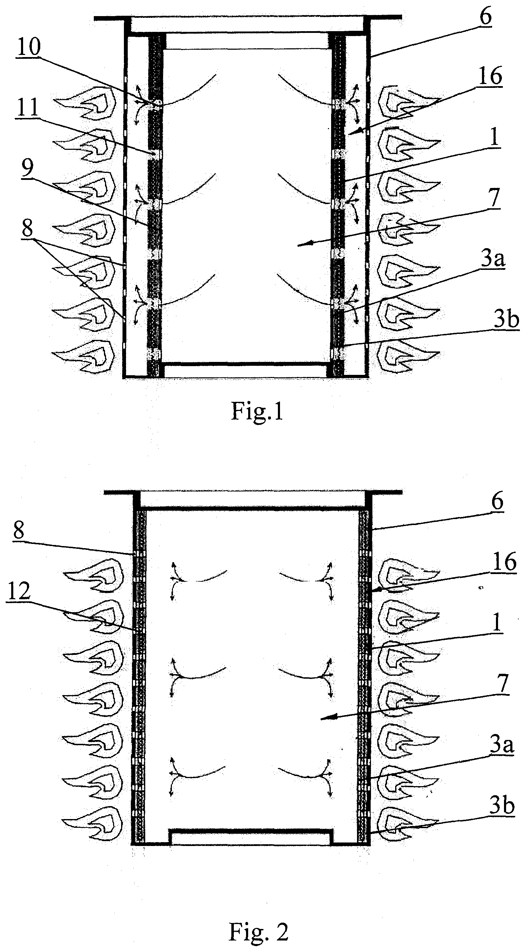

As shown in Fig. 1, the burner comprises an external jacket 6, inside which and at some distance therefrom there is an internal jacket 9, inside which the fuel-and-air duct 7 runs. Applied to the outer side of the internal jacket 9 under the PVD technology, e.g. by evaporation, laser ablation, magnetron sputtering, filtered cathodic arc deposition, or electron beam PVD, is a layered coating 16 which contains a thermoelectric layer 1 having two semi-conductor sub-layers 'p' and 'n' which do not contact each other, the thickness d₁ of which ranges from 1µm to 10µm, preferably amounting to 5 µm, where the sub-layers are formed into alternating rings of the width s falling within the range from 0.1mm to 2mm, preferably amounting to 1mm, and where the rings are interconnected in series with layered conducting elements 2a, 2b made of copper, the thickness d₂ of which ranges from 1µm to 5µm, preferably amounting to 3µm, and where the conducting elements are fitted with end connections 4, 5 to evacuate the generated electric energy. The thermoelectric layer 1 is electrically insulated on conducting elements 2a, 2b with layers 3a, 3b of electrical insulator comprise inorganic oxides, particularly Al₂O₃ or SiO₂ or MgO. In the internal jacket 9 and the coating 16 applied thereto there are pass-through holes 10, 11 positioned co-axially to each other, while formed in the external jacket 6 are nozzles 8 which deliver the fuel-and-air mix from the duct 7 to the outer surface of the external jacket 6, where the mix burns. The cold side of the semiconductor elements 'p' and 'n' of the thermoelectric layer 1 is cooled with air and fuel supplied to the burner, and the hot side stays in thermal contact with the combustion gases and is heated with their heat.

In the second exemplary embodiment of the invention, as shown in Fig. 2, the burner has an external jacket 6, inside which there is a fuel-and-air duct 7, where the burner is fitted with nozzles 8 which deliver the fuel-and-air mix to the outer surface of the external jacket 6, where the mix burns. Applied to the inner surface of the external jacket 6 under the PVD technology, e.g. by evaporation, laser ablation, magnetron sputtering, filtered cathodic arc deposition, or electron beam PVD, is a layered coating 16 which contains a thermoelectric layer 1 having two semi-conductor sub-layers 'p' and 'n', the thickness d₁ of which ranges from 1µm to 10µm, preferably amounting to 5µm, with the width s of the sub-layers ranging from 0.1mm to 2mm, preferably amounting to 1 mm, and where the sub-layers are formed into alternating rings interconnected in series with layered conducting elements 2a, 2b made of copper, the thickness d₂ of which ranges from 1µm to 5µm, preferably amounting to 3µm, and where the conducting elements are fitted with end connections 4, 5 to evacuate the generated electric energy. The coating 16 is fitted with pass-through holes 12 positioned coaxially to the nozzles 8. The thermoelectric layer 1 is electrically insulated on conducting elements 2a, 2b with layers 3a, 3b of electrical insulator produced comprise inorganic oxides, particularly Al₂O₃ or SiO₂ or MgO. The cold side of the semiconductor sub-layers 'p' and 'n' of the thermoelectric layer 1 is cooled with air and fuel supplied to the burner, and the hot side stays in thermal contact with the combustion gases and is heated with their heat.

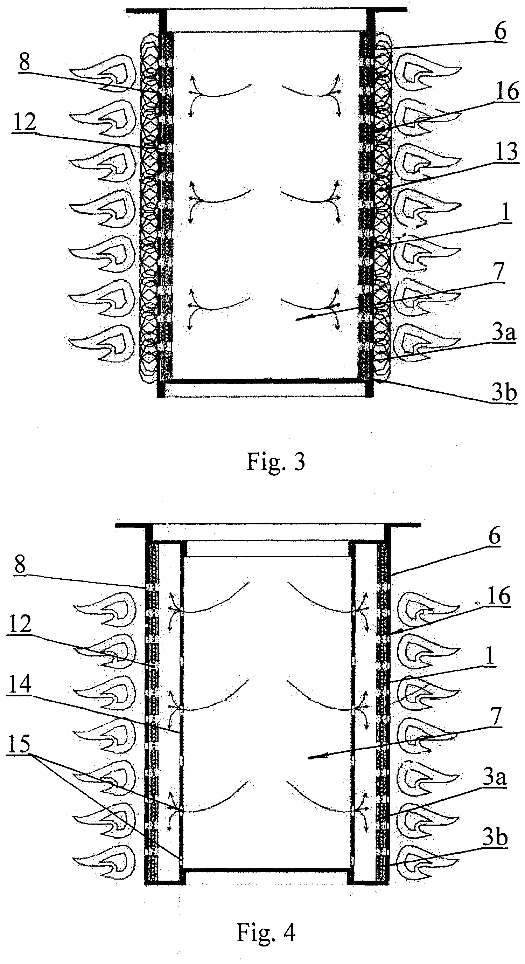

In the third exemplary embodiment of the invention, as shown in Fig. 3, the burner described in embodiment two has a layer 13 of steel non-woven fabric on the outer surface of the external jacket 6.

In the fourth exemplary embodiment of the invention, as illustrated in Fig. 4, the burner described in embodiment two has an internal jacket 14 positioned at some distance from the external jacket 6 featuring a coating 16, where the internal jacket is fitted with pass-through holes 15, and where the fuel-and-air duct 7 runs inside the internal jacket 14.

The total thickness of the thermoelectric layer is 50 µm or less.

First, the process of applying the electrical insulator layer 3a should be performed in the technological chamber, thanks to which the thermoelectric layer 1 will be electrically independent of the base. The insulating layer must be homogenous and continuous in structure. It will make it highly resistant to avalanche breakdown. Then, appropriately located layered conducting elements 2a should be made, which will form the basis and serve as electrical connection between the semiconductor sub-layers. There are many materials which can serve the function. Copper seems a good choice because of the ease of deposition and good conductivity. The most important components of the thermoelectric coating are two semiconductor layers of the 'p' and 'n' types which can be made of the following material groups: lead telluride; tin selenide; telluride, antimony, and bismuth compounds; inorganic occlusion compounds; skutterudite; semi-Heusler compounds; silicon compounds; and germanium compounds. Thanks to the interconnection between two different semiconductor layers 'p' and 'n' achieved using layered conducting elements it will be possible to achieve the flow of current whenever the coating is exposed to temperature difference. The material should be selected according to the criteria of e.g. expected performance, the ensuing thermoelectric efficiency (ZT), and the anticipated range of temperatures to which the coating will be exposed during operation. In the next step, the appropriately located semiconductor sub-layers 'p' and 'n' should be made. Then, appropriately located layered conducting elements 2b should be produced to close the electrical circuit of the thermoelectric layer 1. The last step consists in the producing of the second layer 3b of the electrical insulator. The thermoelectric layer 1 is electrically insulated on conducting elements 2a, 2b with layers 3a, 3b of electrical insulator, produced based on inorganic oxides, particularly Al₂O₃ or SiO₂ or MgO.
The hot side of the thermoelectric layer containing semiconductor sub-layers 'p' and 'n' interconnected in series is in thermal contact with hot combustion gases produced during the burning of fuel in the burner, while the cold side of the same layer is in thermal contact with cold air and fuel flowing into the fuel-and-air duct.
In accordance with Seebeck's theory, the difference in temperature resulting therefrom triggers orderly movement of charges in the semiconductor sub-layers 'p' and 'n' contained in the thermoelectric layer 1. Due to the series connection between the sub-layers, a difference of potential occurs between the outermost connection points, i.e. ends 4, 5. The thus-produced energy can be used to supply power to electronic accessories or external devices, or delivered back to the power grid.

## Claims

1. A burner with a thermoelectric generator, the functioning of which is based on the Seebeck effect, having an external jacket in which nozzles are made which supply the fuel-and-air mix from a fuel-and-air mix duct to the outer surface of the external jacket, where the mix burns, the thermoelectric generator takes the form of a thermoelectric coating (16) applied to these elements of the burner which are in thermal contact with combustion gases, where the coating contains a thermoelectric layer (1) having two semiconductor sub-layers 'p' and 'n' which do not contact each other and are interconnected in series with layered conducting elements (2a, 2b) fitted with connection ends (4, 5) to evacuate the generated electric energy, and where the coating is electrically insulated on conducting elements (2a, 2b) with layers (3a, 3b) of electrical insulator containing inorganic oxides, **characterised in that** the fuel-and-air mix duct (7) is formed inside the external jacket (6), and the width (s) of each semiconductor sub-layer 'p' and 'n' of the thermoelectric layer (1) of the coating (16) ranges from 0.1mm to 2mm, the thickness (d₂) of the layered conducting elements (2a, 2b) falls within the range from 1 µm to 5µm, whereas the total thickness of the coating is 50 µm or less.

2. The burner according to Claim 1, **characterised in that** the cold side of the semiconductor sub-layers 'p' and 'n' of the thermoelectric layer (1) of the coating (16) is cooled with air and fuel supplied to the burner.

3. The burner according to Claim 1, **characterised in that** the layered conducting elements (2a, 2b) of the coating (16) are made of copper.

4. The burner according to Claim 1, **characterised in that** the electrical insulator layers (3a, 3b) of the thermoelectric layer (1) of the coating (16) comprise Al₂O₃ or MgO.

5. The burner according to Claims 1 to 4, **characterised in that** inside the external jacket (6) there is an internal jacket (9) inside which the fuel-and-air duct (7) runs, where applied to the outer side of the internal jacket (9) is the coating (16) which contains the thermoelectric layer (1), and where there are pass-through holes (10, 11) in the internal jacket (9) and the coating (16) applied thereto, the holes positioned coaxially to each other.

6. The burner according to Claims 1 to 4, **characterised in that** the coating (16) which contains the thermoelectric layer (1) is applied to the inner surface of the external jacket (6) and features pass-through holes (12) positioned coaxially to the nozzles (8) delivering the fuel-and-air mix to the outer surface of the external jacket (6).

7. The burner according to Claim 6, **characterised in that** on the outer surface of the external jacket (6) there is a layer (13) of steel non-woven fabric.

8. The burner according to Claim 6 or 7, **characterised in that** it has an internal jacket (14) featuring pass-through holes (15), where there is a fuel-and-air duct (7) running inside the internal jacket.

9. The burner according to Claims 1 to 8, **characterised in that** the semiconductor layers 'p' and 'n' of the thermoelectric layer (1) of the coating (16) are formed into alternating semiconductor rings 'p' and 'n'.

## Patentansprüche

1. Ein Brenner mit einem thermoelektrischen Generator, der nach dem Seebeck-Effekt betrieben wird, mit einen Außenmantel, in dem Düsen ausgeführt sind, die das Brennstoff-Luft-Gemisch aus dem Brennstoff-Luft-Gemisch-Kanal an die Außenfläche des Außenmantels fördern, wo dieses verbrannt wird, ein thermoelektrischer Generator besteht aus einer dünnen thermoelektrischen Beschichtung (16) an den Brennerelementen, die thermischen Kontakt mit den Rauchgasen haben, wobei die Beschichtung eine thermoelektrische Schicht (1) mit zwei Halbleiter-Unterschichten "p" und "n" aufweist, die sich nicht berühren und die mit leitenden Elementen (2a, 2b) in Reihe miteinander angeordnet sind, die mit Anschlussklemmen (4, 5) zur Ableitung des generierten Stroms versehen sind, und die an leitenden Elementen (2a, 2b) mit Schichten (3a, 3b) des elektrischen Isolators mit anorganischen Oxiden elektrisch isoliert ist, **dadurch gekennzeichnet, dass** der Brennstoff-Luft-Gemisch-Kanal (7) im Innenraums des Außenmantels (6) ausgebildet ist und die Breite (s) jeder Halbleiter-Unterschicht "p" und "n" der thermoelektrischen Schicht (1) der Beschichtung (16) zwischen 0,1 mm und 2 mm liegt, die Dicke (d₂) der leitenden Elemente (2a, 2b) zwischen 1 µm und 5 µm liegt, wobei die Gesamtdicke der thermoelektrischen Beschichtung 50 µm oder weniger beträgt.

2. Brenner nach Anspruch 1, **dadurch gekennzeichnet, dass** die kalte Seite der Halbleiter-Unterschichten "p" und "n" der thermoelektrischen Schicht (1) der Beschichtung (16) mit Luft und Brennstoff, die dem Brenner zugeführt werden, gekühlt wird.

3. Brenner nach Anspruch 1, **dadurch gekennzeichnet, dass** die leitenden Elemente (2a, 2b) der Beschichtung (16) aus Kupfer ausgeführt sind.

4. Brenner nach Anspruch 1, **dadurch gekennzeichnet, dass** die Schichten (3a, 3b) des elektrischen Isolators der thermoelektrischen Schicht (1) der Beschichtung (16) Al2O3 oder SiO₂ oder MgO enthalten.

5. Brenner nach Ansprüchen 1 bis 4, **dadurch gekennzeichnet, dass** der innere Mantel (9) im äußeren Mantel (6) liegt und ein Brennstoff-Luft-Kanal (7) enthält, und auf der Außenseite des inneren Mantels (9) eine Beschichtung (16) aufgetragen ist, die eine thermoelektrische Schicht (1) enthält, wobei im inneren Mantel (9) und in der darauf aufgetragenen Beschichtung (16) durchgehende Bohrungen (10, 11) vorhanden sind, die koaxial zueinander angeordnet sind.

6. Brenner nach Ansprüchen 1 bis 4, **dadurch gekennzeichnet, dass** die Beschichtung (16), die die thermoelektrische Schicht (1) enthält, auf der Innenfläche des Außenmantels (6) aufgebracht ist und mit durchgehenden Bohrungen (12) versehen ist, die koaxial zu Düsen (8) angeordnet sind, die das Brennstoff-Luft-Gemisch an die Außenfläche des Außenmantels (6) zuführen.

7. Brenner nach Anspruch 6, **dadurch gekennzeichnet, dass** eine Stahlgewebeschicht (13) an der Außenfläche des Außenmantels (6) angebracht ist.

8. Brenner nach Anspruch 6 oder 7, **dadurch gekennzeichnet, dass** er einen Innenmantel (14) aufweist, der mit durchgehenden Bohrungen (15) versehen ist, in denen sich ein Brennstoff-Luft-Kanal (7) befindet.

9. Brenner nach Ansprüchen 1 bis 8, **dadurch gekennzeichnet, dass** die Halbleiter-Unterschichten "p" und "n" der thermoelektrischen Schicht (1) der Beschichtung (16) in Form alternierender Halbleiterringe "p" und "n" ausgebildet sind.

## Revendications

1. Brûleur doté d'un générateur thermoélectrique fonctionnant selon le phénomène Seebeck, ayant une enveloppe extérieure dans laquelle sont réalisées des buses alimentant le mélange carburant-air du canal de mélange air-carburant à la surface extérieure de l'enveloppe extérieure, où il est brûlé, le générateur thermoélectrique est une mince couche thermoélectrique (16) appliqué sur les éléments du brûleur en contact thermique avec les gaz d'échappement, le revêtement comprenant une couche thermoélectrique (1) ayant deux sous-couches semi-conductrices sans contact "p" et "n" connectées en série avec des éléments conducteurs (2a, 2b), équipé de bornes de connexion (4, 5) pour décharger l'électricité résultante, et quelle coucheest électriquement isolée sur les éléments conducteurs (2a, 2b) avec des couches (3a, 3b) d'un isolant électrique contenant des oxydes inorganiques, **caractérisé en ce que** le canal de mélange air-carburant (7) est formé à l'intérieur de l'enveloppe extérieure (6), et la ou les largeurs de chaque sous-couche semiconductrice "p" et "n" de la couche thermoélectrique (1) de la couche (16) est de 0,1 mm à 2 mm, l'épaisseur (d₂) des éléments conducteurs (2a, 2b) est dans la plage de 1 µm à 5 µm, l'épaisseur totale de la couche thermoélectrique étant de 50µm ou moins.

2. Brûleur selon la revendication 1, **caractérisé en ce que** le côté froid des sous-couches semi-conductrices "p" et "n" (1) de la couche thermoélectrique (1) de la couche (16) est refroidi par de l'air et du carburant alimentant le brûleur.

3. Brûleur selon la revendication 1, **caractérisé en ce que** les éléments conducteurs (2a, 2b) de la couche (16) sont en cuivre.

4. Brûleur selon la revendication 1, **caractérisé en ce que** les couches (3a, 3b) de l'isolant électrique de la couche thermoélectrique (1) du revêtement (16) contiennent Al₂O₃ ou SiO₂ ou MgO.

5. Brûleur selon les revendications 1 à 4, **caractérisé en ce que** à l'intérieur de l'enveloppe extérieure (6), il y a une enveloppe intérieure (9) à l'intérieur de laquelle se trouve un canal air-carburant (7), et sur le côté extérieur de l'enveloppe intérieure (9) une couche (16) contenant une couche thermoélectrique (1) est appliqué, l'enveloppe intérieure (9) et la couche (16) appliquée dessus ayant des ouvertures traversantes (10, 11) disposées coaxialement l'un avec l'autre.

6. Brûleur selon les revendications 1 à 4, **caractérisé en ce que** la couche (16) contenant la couche thermoélectrique (1) est appliqué sur la surface intérieure de l'enveloppe extérieure (6) et est pourvu de trous traversants (12) disposés coaxialement aux buses (8) fournissant le mélange air-carburant à la surface extérieure de l'enveloppe extérieure (6).

7. Brûleur selon la revendication 6, **caractérisé en ce que** sur la surface extérieure de l'enveloppe extérieure (6) se trouve une couche (13) en acier non tissé.

8. Brûleur selon la revendication 6 ou 7, **caractérisé en ce qu'**il possède une enveloppe intérieure (14), équipée de ouvertures traversantes (15) à l'intérieur desquels se trouve un canal air-carburant (7).

9. Brûleur selon les revendications 1 à 8, **caractérisé en ce que** les sous-couches semi-conductrices "p" et "n" de la couche thermoélectrique (1) de la couche (16) sont formées sous la forme d'anneaux semi-conducteurs alternés "p" et "n".
